**Europäisches Patentamt**

**European Patent Office**

**Office européen des brevets**

(11) Veröffentlichungsnummer: **0 052 746**
**B1**

(12) **EUROPÄISCHE PATENTSCHRIFT**

(45) Veröffentlichungstag der Patentschrift:
**07.01.88**

(51) Int. Cl.⁴: **H 01 L 27/08, G 11 C 11/34,**
**H 01 L 21/76, H 01 L 21/265**

(21) Anmeldenummer: **81108292.4**

(22) Anmeldetag: **13.10.81**

(54) **Dynamische Halbleiter-Speicherzelle mit wahlfreiem Zugriff und Verfahren zu ihrer Herstellung.**

(30) Priorität: **24.11.80 DE 3044132**

(43) Veröffentlichungstag der Anmeldung:
**02.06.82 Patentblatt 82/22**

(45) Bekanntmachung des Hinweises auf die Patenterteilung:
**07.01.88 Patentblatt 88/1**

(84) Benannte Vertragsstaaten:
**DE FR GB**

(56) Entgegenhaltungen:
**DE - A - 2 425 942**
**DE - A - 2 650 865**
**US - A - 4 035 829**

**S.M. Sze: "Semiconductor Devices", J. Wiley & Sons,**
**New York 1985, S. 486-490.**
**IEEE J. Solid-State Circuits, Vol. SC-11, No. 5, Okt. 1976,**
**S. 570-573.**
**IEEE Internat. Electron-Devices-Meeting, Techn.**
**Digest, Washington DC, Dez. 1973, S. 371-373**

(73) Patentinhaber: **Siemens Aktiengesellschaft Berlin und**
**München, Wittelsbacherplatz 2, D-8000 München 2 (DE)**

(72) Erfinder: **Müller, Wolfgang, Dr.,**
**Theodor-Heuss-Strasse 12, D-8011 Putzbrunn (DE)**

ACTORUM AG

## Beschreibung

Die vorliegende Patentanmeldung betrifft eine dynamische Halbleiter-Speicherzelle mit wahlfreiem Zugriff (RAM = random access memory) mit einer ersten auf dem Halbleiterkörper isoliert aufgebrachten Polysiliziumschichtstruktur, die Polysilizium-1-Elektroden als Speicherelektroden für die im Halbleiterkörper erzeugten Speicherbereiche bildet, und einer von der ersten Polysiliziumschichtstruktur isoliert aufgebrachten zweiten Polysiliziumschichtstruktur, die Polysilizium-2-Wortleitungen bildet, sowie ein Verfahren zur Herstellung der Speicherzelle.

Der Doppel-Polysilizium-Gate (Si²-Gate)-Prozess ist als Standardprozess für die Realisierung von dynamischen RAM-Speichern anzusehen. Eine Speicherzelle der eingangs genannten Art und der entsprechende Si²-Gate-Prozess für die Herstellung eines dynamischen 16 384-Bit-Speichers mit wahlfreiem Zugriff ist aus dem IEEE Journal of Solid-State Circuits, Vol. SC-11, Oct. 1976, Seite 570 bis 573, zu entnehmen.

Mit der derzeit erreichbaren Strukturauflösung der Fotolithographie von etwa 1,5 μm wurde, wie aus dem Tagungsband ISSCC 15. Febr. 1980, Digest of Techn. Papers, Seite 232/233 zu entnehmen ist, bereits eine 256 K-dynamische RAM-Speicherzelle realisiert. Die Isolation zwischen benachbarten aktiven Bereichen (Transistoren, Speicherkondensatoren, diffundierten Zonen) wird hierbei, wie auch bei der zuerst genannten Speicherzelle, durch Dickoxidbereiche der sogenannten LOCOS-Technologie realisiert. Das LOCOS-Verfahren (= local oxidation of silicon) ist ein Isolationsverfahren für integrierte Schaltungen mit hoher Packungsdichte. Als Isoliermaterial zwischen den aktiven Transistorbereichen wird Siliziumdioxid (SiO₂) verwendet. Nach selektiver Abscheidung einer Oxid- und einer Nitrid-Schicht erfolgt eine lokale Oxidation in der nitridfreien Zone, wobei eine starke laterale Unteroxidation (sogenannter Vogelschnabel, birds beak) und eine starke laterale Ausdiffusion der Feldimplantation, welche eine starke Weitenabhängigkeit der Einsatzspannung schmaler Transistoren zur Folge hat, stattfindet. LOCOS-Prozesse dieser Art sind aus den Philips Research Reports, Vol. 26, No. 3, June 1971, auf den Seiten 157 bis 165 beschrieben. Bei dieser Isolationstechnik kann – wegen der graduellen Übergänge zwischen Dickoxid- und Dünnoxidbereichen (Vogelschnabel) von etwa 0,5 μm Länge – für den Isolationsabstand nicht die minimale Strukturabmessung realisiert werden. Der minimal mögliche Isolationsabstand der LOCOS-Isolation liegt deshalb um die doppelte Vogelschnabellänge über dem minimalen Strukturmass. Daraus folgt, dass im Falle der aus dem Tagungsband ISSCC 1980 bekannten 256 K-RAM-Speicherzelle ein zusätzlicher Platzbedarf von etwa 25% der Zellfläche erforderlich ist.

Die Aufgabe, die der Erfindung zugrundeliegt, besteht nun darin, dynamische RAM-Speicherzellen mit Doppel-Polysilizium-Gate-Technologie, wie sie beispielsweise in dem IEEE Journal of Solid State Circuits, Vol. SC-11, Oct. 1976, S. 570–573, beschrieben sind, in Richtung Verkleinerung des Flächenbedarfs, Vereinfachung des technologischen Prozesses und Verbesserung der elektrischen Eigenschaften wie Refreshzeiten und Weitenabhängigkeit der Einsatzspannung zu verbessern und damit eine Alternative zur LOCOS-Isolation zu schaffen.

Diese Aufgabe wird bei einer dynamischen Halbleiter-Speicherzelle mit wahlfreiem Zugriff der eingangs genannten Art erfindungsgemäss dadurch gelöst, dass zur Isolation der benachbarten Speicherbereiche vom zweiten Leitungstyp im Halbleiterkörper vom ersten Leitungstyp unter der ersten Polysiliziumschichtstruktur durch Implantation von Ionen vom ersten Leitungstyp eine Erhöhung der Substratdotierung an der Oberfläche vorgesehen ist, wodurch ein Feldplattenisolationsbereich vom ersten Leitungstyp durch einen Transistor im Sperrzustand entsteht, und dass die Speicherbereiche durch Implantation von Ionen vom zweiten Leitungstyp selbstleitend sind, so dass für eine Spannung an der Speicherelektrode von 0 Volt die volle Betriebsspannung in die Speicherkapazität eingeschrieben werden kann.

Diese sogenannte Field-Shield-Isolation ist aus dem Tagungsband IEEE Internat. Electron-Devices-Meeting, Techn. Digest Washington DC, Dec. 1973 auf den Seiten 371 bis 373 zur Herabsetzung der Leckströme bei n-Kanal-Silizium-Gate-Feldeffekttransistoren in Silizium-Aluminium-Technologie bekannt. Die Field-Shield-Isolation lässt sich beim Doppel-Silizium-Gate-Prozess sehr gut einsetzen. Dabei wirkt die zuerst aufgebrachte Polysiliziumschicht (Poly 1-Ebene) im Speicherbereich sowohl als Speicherelektrode (wie beim herkömmlichen Doppel-Silizium-Gate-RAM-Prozess) als auch zusätzlich als Feldplattenelektrode, wenn die beiden verschiedenen Bereiche entsprechend dotiert sind. In der Peripherie fungiert die Polysilizium-1-Ebene nur als Feldplattenelektrode.

Zur Realisierung wird ein Verfahren zum Herstellen von dynamischen Halbleiterspeichern mit wahlfreiem Zugriff (RAM) vorgeschlagen, welches erfindungsgemäss dadurch gekennzeichnet ist, dass zur Isolation der einzelnen Speicherbereiche vom zweiten Leitungstyp nach dem Erzeugen der Gateoxidschicht und vor dem Erzeugen der Speicherbereiche durch eine maskierte Ionenimplantation zur Erhöhung der Substratdotierung an der Oberfläche eine ganzflächige Implantation mit Ionen vom ersten Leitungstyp durchgeführt wird.

Ein Verfahren, bei dem zur Erzeugung von Isolierbereichen zwischen benachbarten Schaltungskomponenten jeweils durch eine oberflächlich auf das Substrat aufgebrachte Oxidschicht eine grossflächige Ionenimplantation geeigneten Leitungstyps und anschliessend mit Hilfe einer zusätzlichen Maskierungsschicht lokal eine Ionenimplantation des entgegengesetzten Leitungstyps durchgeführt wird, ist aus der DE-A-2 650 865 bekannt.

Das erfindungsgemässe Verfahren ist im einzelnen durch den Ablauf folgender Verfahrensschritte gekennzeichnet:

a) Erzeugen einer als Gateoxid wirkenden thermischen Oxidschicht auf einem p-dotierten Siliziumsubstrat,

b) Durchführung einer ganzflächigen Bor-Implantation zur Einstellung der Einsatzspannung der Isolationsbereiche (Enhancement Implantation),

c) Durchführung einer Fotolacktechnik zur Definition der Speicherbereiche,

d) Erzeugung der Speicherbereiche durch eine Arsen-Ionenimplantation (Depletion Implantation),

e) Entfernung der Fotolackstrukturen,

f) Abscheidung der ersten Polysiliziumschicht und Strukturierung der Polysilizium-1-Elektrode,

g) Erzeugung des Isolationsoxids,

h) Abscheidung der zweiten Polysiliziumschicht und Strukturierung der Polysilizium-2-Wortleitungen,

i) Erzeugung der Source/Drain-Bereiche durch Arsen-Ionenimplantation,

j) Aufbringen des Zwischenoxids,

k) Durchführung der Kontaktlochätzung zu den Source/Drain-Bereichen,

l) ganzflächige Metallisierung und Strukturierung der Leiterbahnen und

m) Passivierung des fertigen Bauelements.

Wie der hier geschilderte Prozessablauf zeigt, bringt das erfindungsgemässe Verfahren mit der Field-Shield-Isolation ein gegenüber dem LOCOS-Prozess wesentliche Vereinfachung der technologischen Schritte. Die Schritte zur Erzeugung der Dickoxidbereiche (Nitrid/Oxid-Abscheidung, Nitrid-Abscheidung, Nitrid-Strukturierung durch erste Maske, Feldimplantation, Feldoxidation, Oxid/Nitrid-Ätzung, Nitrid entfernen, Nitrid-Oxid-Aufoxidation und Nitrid-Oxid entfernen) entfallen.

Weitere Einzelheiten und Vorteile der Erfindung sind im folgenden anhand der Figuren 1 bis 9 in einem Ausführungsbeispiel noch näher erläutert. Dabei zeigen

die Figuren 1 bis 4 die für die Erfindung wesentlichen Verfahrensschritte,

die Figur 5 als Layout einen Ausschnitt aus dem Speicherbereich und

die Figuren 6 bis 9 im Schnittbild einen Vergleich der LOCOS-Isolation mit der Feldplattenisolation für die Isolation zweier benachbarter Speicherzellen (Figur 6 und 7) und für die Isolation Polysilizium-2-Gatebereiche und $n^+$ diffundiertes Gebiet (Figur 8 und 9).

In allen Figuren gelten für gleiche Teile die gleichen Bezugszeichen.

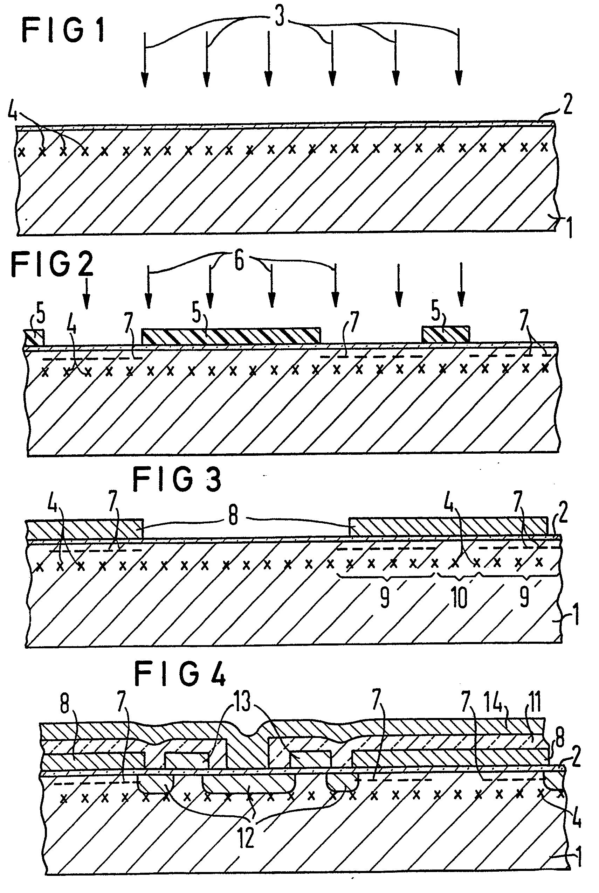

Figur 1 zeigt ein p-dotiertes Siliziumsubstrat 1 (20 Ohm · cm), auf dessen Oberfläche eine thermische Oxidschicht 2 als Gateoxidschicht in einer Schichtstärke von 25 nm aufgewachsen ist. Durch die Oxidschicht 2 erfolgt eine Implantation (siehe Pfeile 3) von Bor-Ionen. Die im Siliziumsubstrat 1 implantierten Bor-Ionen sind mit 4 gekennzeichnet. Die Bor-Implantation wird zur Einstellung der Einsatzspannung der Isolationsbereiche von etwa 1 V in einem ersten Implantationsschritt mit $7 \times 10^{11}$ B cm$^{-2}$ und 25 keV und in einem zweiten Implantationsschritt mit $1{,}5 \times 10^{11}$ B cm$^{-2}$ bei 140 keV durchgeführt. Es kann auch nur ein Implantationsschritt durchgeführt werden, wobei die Implantationsdosis auf $8 \times 10^{11}$ B cm$^{-2}$ bei 60 keV eingestellt wird.

In Figur 2 werden mit Hilfe einer Implantationsmaske 5 aus Fotolack die Speicherbereiche (9) definiert und dann eine Arsen-Implantation (siehe Pfeile 6) durchgeführt, wobei zur Einstellung einer Einsatzspannung der Speicherbereiche von $-5$ V die Implantationsdosis auf $5 \times 10^{12}$ As cm$^{-2}$ bei 80 keV eingestellt wird. Die im Substrat 1 implantierten Arsen-Ionen sind mit 7 bezeichnet.

Figur 3: Nach Entfernen der Lackmaske 5 wird dann die Polysilizium-1-Schicht aufgebracht und anschliessend durch ein anisotropes Ätzverfahren, vorzugsweise durch reaktives Sputterätzen in einem Sauerstoff-Freon ($= CF_4$ oder $CHF_3$)-Gemisch so strukturiert, dass die Polysilizium-1-Elektroden 8 gebildet werden. Die Figur 3 kennzeichnet in geschweiften Klammern die im Substrat 1 entstandenen Speicherbereiche 9, sowie den Field-Shield-Isolationsbereich 10. Damit ist sichergestellt, dass bei einer Spannung von 0 V an der Polysilizium-1-Elektrode 8 sowohl die Field-Shield-Bereiche 10 isolieren, als auch der zur Verfügung stehende Spannungshub $V_{DD}$ ($=$ Betriebsspannung) von 5 V in die Zelle eingeschrieben werden kann.

Der weitere Prozessverlauf, wie das Erzeugen des Isolationsoxids, Abscheidung der zweiten Polysiliziumschicht und Strukturierung der Polysilizium-2-Wortleitungen, Erzeugung der Source/Drain-Bereiche durch Arsen-Implantation, Aufbringen des Zwischenoxids, Durchführung der Kontaktlochätzung zu den Source/Drain-Bereichen, ganzflächige Metallisierung und Strukturierung der Leiterbahnen, sowie die Passivierung des fertigen Bauelements verläuft nach bekannten Verfahrensschritten. Auf detaillierte Abbildungen wurde hier verzichtet.

Die Figur 4 zeigt im Schnittbild die Struktur am Prozessende. Mit dem Bezugszeichen 11 ist das Zwischenoxid, mit 12 die Source/Drain-Bereiche, mit 13 die Polysilizium-2-Wortleitungen und mit 14 die Metalleitbahnen bezeichnet.

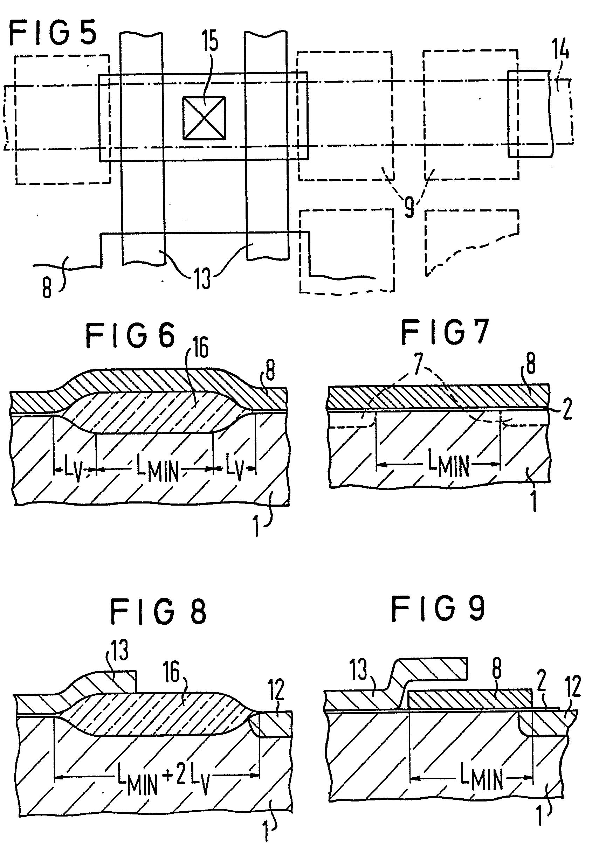

Figur 5 zeigt einen Ausschnitt aus einer nach dem erfindungsgemässen Verfahren hergestellten Speicherzelle in Draufsicht. Es gelten die gleichen Bezugszeichen wie in den Figuren 3 und 4. Mit 15 ist der Bereich des Kontaktloches zu den Source/Drain-Bereichen bezeichnet.

Wie aus den Figuren 6 und 7 zu entnehmen ist, ist der minimale Isolationsabstand für die Field-Shield-Isolation (Figur 7) durch das minimale Strukturmass $L_{Min}$ auf der Implantationsmaske bestimmt, während bei der LOCOS-Isolation (Figur 6) der minimal mögliche Isolationsabstand um die doppelte Vogelschnabellänge $L_V$ über dem minimalen Strukturmass $L_{Min}$ liegt. Der Bereich 16 kennzeichnet das Dickoxid, welches im Bereich der Speicherzelle nach Figur 7 entfällt.

Die Figuren 8 und 9 zeigen einen Vergleich der LOCOS (Figur 8) – mit der Field-Shield-Isolation (Figur 9) zwischen Polysilizium-2-Gatebereich 13 und $n^+$-diffundiertem Gebiet 12. Wegen der hohen Genauigkeit in der Strukturübertragung beim Einsatz anisotroper Ätzverfahren zur Strukturierung der Polysilizium-1-Field-Shield-Elektrode 8 kann auch in diesem Fall bei Field-Shield-Isolation das minimale Strukturmass $L_{Min}$ als Isolationsabstand realisiert werden.

Neben dem Gewinn in der Packungsdichte und Einsparungen in den technologischen Schritten lassen sich bei Field-Shield-Isolation auch eine Verbesserung der elektrischen Eigenschaften erwarten. An den Dickoxidbereichen der LOCOS-Isolation führen Störungen der Kristallstruktur zu erhöhter Generation, so dass zusätzliche Massnahmen (Getterschritte) getroffen werden müssen, um eine genügend lange Relaxationszeit des Speicherzustands zu garantieren. Die ideale planare Struktur im Falle der Field-Shield-Isolation, wie sie in Figur 7 dargestellt ist, lässt ein wesentlich verbessertes Verhalten erwarten.

Eine weitere Verbesserung lässt sich bezüglich der Weitenabhängigkeit der Einsatzspannung der Polysilizium-2-Transistoren (Transfergates) erwarten. Bei LOCOS-Isolation ist die Weitenabhängigkeit der Polysilizium-2-Transistoren vor allem durch die laterale Diffusion der Feldimplantation bestimmt. Bei Field-Shield-Isolation (Figur 9) ist die Dotierung unter der Polysilizium-1-Field-Shield- und Polysilizium-2-Gate-Elektrode bei gleicher Oxiddicke gleich. Die Weitenabhängigkeit der Einsatzspannung sollte daher das bestmögliche Verhalten zeigen.

Die Anwendung der Field-Shield-Isolation ist nicht auf dynamische RAM-Speicher begrenzt. Die für die Speicherperipherie anhand von Figur 9 diskutierten Verbesserungen lassen sich auch auf Logikschaltungen übertragen.

**Patentansprüche**

1. Dynamische Halbleiterspeicherzelle mit wahlfreiem Zugriff (RAM) mit einer ersten auf dem Halbleiterkörper (1) isoliert aufgebrachten Polysiliziumschichtstruktur (8), die Polysilizium-1-Elektroden als Speicherelektroden für die im Halbleiterkörper (1) erzeugten Speicherbereiche (9) bildet, und einer von der ersten Polysiliziumschichtstruktur (8) isoliert aufgebrachten zweiten Polysiliziumschichtstruktur (13), die Polysilizium-2-Wortleitungen bildet, dadurch gekennzeichnet, dass zur Isolation der benachbarten Speicherbereiche (9) vom zweiten Leitungstyp im Halbleiterkörper (1) vom ersten Leitungstyp unter der ersten Polysiliziumschichtstruktur (8) durch Implantation von Ionen (3) vom ersten Leitungstyp eine Erhöhung der Substratdotierung an der Oberfläche vorgesehen ist, wodurch ein Feldplattenisolationsbereich (10) vom ersten Leitungstyp durch einen Transistor im Sperrzustand entsteht, und dass die Speicherbereiche (9) durch Implantation von Ionen (6) vom zweiten Leitungstyp selbstleitend sind, so dass für eine Spannung an der Speicherelektrode (8) von 0 Volt die volle Betriebsspannung in die Speicherkapazität eingeschrieben werden kann.

2. Verfahren zum Herstellen von dynamischen Halbleiterspeichern mit wahlfreiem Zugriff (RAM) in Doppelpolysiliziumgate-Technologie nach Anspruch 1, dadurch gekennzeichnet, dass zur Isolation der einzelnen benachbarten Speicherbereiche (9) vom zweiten Leitungstyp nach dem Erzeugen der Gateoxidschicht (2) und vor dem Erzeugen der Speicherbereiche (9) durch maskierte Ionenimplantation (5) zur Erhöhung der Substratdotierung (1) an der Oberfläche eine ganzflächige Implantation von Ionen (3) vom ersten Leitungstyp durchgeführt wird.

3. Verfahren nach Anspruch 2, gekennzeichnet durch den Ablauf folgender Verfahrensschritte:

a) Erzeugen einer als Gateoxid wirkenden thermischen Oxidschicht (2) auf einem p-dotierten Siliziumsubstrat (1),

b) Durchführung einer ganzflächigen Bor-Implantation (3) zur Einstellung der Einsatzspannung der Isolationsbereiche,

c) Durchführung einer Fotolacktechnik (5) zur Definition der Speicherbereiche (9),

d) Erzeugung der Speicherbereiche (9) durch eine Arsen-Ionenimplantation (6),

e) Entfernung der Fotolackstrukturen (5),

f) Abscheidung der ersten Polysiliziumschicht und Strukturierung der Polysilizium-1-Elektrode (8),

g) Erzeugen des Isolationsoxids,

h) Abscheidung der zweiten Polysiliziumschicht und Strukturierung der Polysilizium-2-Wortleitungen (13),

i) Erzeugen der Source/Drain-Bereiche (12) durch Arsen-Ionenimplantation,

j) Aufbringen des Zwischenoxids (11),

k) Durchführung der Kontaktlochätzung (15) zu den Source/Drain-Bereichen (12),

l) ganzflächige Metallisierung und Strukturierung der Leiterbahnen (14),

m) Passivierung des fertigen Bauelements.

4. Verfahren nach Anspruch 2 und 3, dadurch gekennzeichnet, dass zur Einstellung der Einsatzspannung der Isolationsbereiche (10) eine ganzflächige Implantation mit Bor (3) durchgeführt wird, wobei bei einer Gateoxiddicke (2) von 25 nm die Implantationsdosis auf $8 \times 10^{11}$ B $cm^{-2}$ bei 60 keV eingestellt wird.

5. Verfahren nach Anspruch 2 bis 4, dadurch gekennzeichnet, dass zur Erzeugung der Speicherbereiche (9) eine Arsen-Ionen-Implantation (6) bei $5 \times 10^{12}$ As $cm^{-2}$ bei 80 keV durchgeführt wird.

6. Verfahren nach Anspruch 2 bis 5, dadurch gekennzeichnet, dass zur Strukturierung der Polysilizium-1-Elektroden (8) ein anisotropes Ätzverfahren, vorzugsweise ein reaktives Sputterätzen in einem Freon ($CF_4$ oder $CHF_3$)-Sauerstoff-Gemisch verwendet wird.

**Claims**

1. A dynamic semiconductor storage cell with random access (RAM) comprising a first polysilicon layer structure (8) which is applied to the semiconductor body (1) in insulated fashion and forms polysilicon-1-electrodes as storage electrodes for the storage zones (9) produced in the semiconductor body (1), and a second polysilicon layer structure (13) which is so applied as to be insulated from the first polysilicon layer structure (8) and forms the polysilicon-2-wordlines, characterised in that in order to insualte the adjacent storage zones (9) of the second conductivity type in the semiconductor body (1) of the first conductivity type, beneath the first polysilicon layer structure (8) and increase in the substrate doping at the surface is achieved by the implantation of ions (3) of the first conductivity type, as a result of which a field shield insulating zone (10) of the first conductivity type is formed by a transistor in the blocked state, and that the storage zones (9) are self-conducting as a result of the implantation of ions (6) of the second conductivity type, so that when a voltage of zero volts is connected to the storage electrode (8), the full operating voltage can be input into the storage capacitance.

2. A process for the production of dynamic semiconductor stores with random access (RAM) using double polysilicon gate technology as claimed in Claim 1, characterised in that for the insulation of the individual adjacent storage zones (9) of the second conductivity type, after the production of the gate oxide layer (2) and before the production of the storage zones (9) by masked ion implantation (5), in order to increase the substrate doping (1) at the surface, ions (3) of the first conductivity type are implanted into the entire surface.

3. A process as claimed in Clain 2, characterised by the sequence of the following process steps:

a) production of a thermal oxide layer (2) acting as gate oxide, on a p-doped silicon substrate (1),

b) carrying out of boron implantation (3) over the entire surface in order to set the start voltage of the insulating zones,

c) carrying out of a photo-resist step (5) to define the storage zones (9),

d) production of the storage zones (9) by the implantation of arsenic ions (6),

e) removal of the photo-resist structures (5),

f) deposition of the first polysilicon layer and structuring to form the polysilicon-1-electrodes (8),

g) production of the insulating oxide,

h) deposition of the second polysilicon layer and structuring to form the polysilicon-2-wordlines (13),

i) production of the source/drain zones (12) by the implantation of arsenic ions,

j) application of the intermediate oxide (11),

k) etching of contact holes (15) to the source/drain zones (12),

l) metallisation of the whole surface and structuring to form the conductor paths (14),

m) passivation of the finished component.

4. A process as claimed in Claims 2 and 3, characterised in that to set the start voltage of the insulating zones (10), boron is implanted into the entire surface (3), the implantation dose, with a gate oxide thickness (2) of 25 nm, being set at $8 \times 10^{11}$ B cm$^{-2}$ at 60 keV.

5. A process as claimed in Claim 2 to 4, characterised in that for the production of the storage zones (9) an arsenic ion implantation (6) is carried out at $5 \times 10^{12}$ As cm$^{-2}$ at 80 keV.

6. A process as claimed in Claim 2 to 5, characterised in that for the structuring to form the polysilicon-1-electrodes (8), an anisotropic etching process, preferably reactive sputter etching, is used in a Freon ($CF_4$ or $CHF_3$)-oxygen mixture.

**Revendications**

1. Cellule de mémoire à semi-conducteurs à accès aléatoire (RAM), dynamique, comprenant une première structure de couche de polysilicium (8), appliquée sur le corps semi-conducteur (1) de manière qu'elle y soit isolée et qui forme des électrodes de polysilicium (1) en tant qu'électrodes de mémoire pour les zones de mémoire (9) créées dans le corps semi-conducteur (1), et une seconde structure de couche de polysilicium (13), appliquée de manière qu'elle soit isolée de la première structure de couche de polysilicium (8) et qui forme des lignes de mot de polysilicium 2, caractérisée en ce que, pour isoler les zones de mémoire (9) voisines, du second type de conductivité, dans le corps semi-conducteur (1), qui est du premier type de conductivité, sous la première structure de couche de polysilicium (8), il est prévu une augmentation du dopage du substrat en surface, par implantation d'ions (3) du premier type de conductivité, de sorte qu'il se forme une zone isolante à magnétorésistance (10) du premier type de coductivité par un transistor à l'état bloqué, et que les zones de mémoire (9) sont auto-conductrices par suite d'une implantation d'ions (6) du second type de conductivité, de sorte que pour une tension de 0 volt sur l'électrode de mémoire (8), toute la tension de service peut être inscrite dans la capacité de mémorisation.

2. Procédé pour fabriquer des mémoires à semi-conducteurs à accès aléatoire (RAM), dynamiques, en technologie à grille de polysilicon double, selon la revendication 1, caractérisé en ce que, pour isoler les zones de mémoire (9) individuelles voisines, du second type de conductivité, on effectue sur toute la surface une implantation d'ions (3) du premier type de conductivité, après la création de la couche d'oxyde de grille (2) et avant la création des zones de mémoire (9), par implantation d'ions (5) avec masquage, afin d'augmenter le dopage du substrat (1) en surface.

3. Procédé selon la revendication 2, caractérisé en ce qu'il comprend des opérations suivantes:

a) formation d'une couche d'oxyde thermique (2), agissant comme oxyde de grille, sur un substrat de silicium (1) dopé p;

b) réalisation d'une implantation de bore (3) sur toute la surface pour ajuster la tension du seuil des zones d'isolement;

c) application d'une technique de photorésist (5) pour la définition des zones de mémoire (9);

d) formation des zones de mémoire (9) par une implantation d'ions d'arsenic (6);

e) enlèvement des structures de photorésist (5);

f) dépôt de la première couche de polysilicium et structuration de l'électrode (8) de polysilicium 1;

g) formation de l'oxyde isolant;

h) dépôt de la seconde couche de polysilicium et structuration des lignes de mot (13) de polysilicium 2;

i) formation des zones (12) de source/drain par implantation d'ions d'arsenic;

j) application de l'oxyde intermédiaire (11);

k) réalisation de la gravure du trou de contact (15) menant aux zones de source/drain (12);

l) métallisation de toute la surface et structuration des pistes conductives (14);

m) passivation du composant terminé.

4. Procédé selon les revendications 2 et 3, caractérisé en ce que, pour ajuster la tension de seuil des zones d'isolement (10), on effectue une implantation de bore (3) sur toute la surface, en réglant la dose d'implantation à $8 \times 10^{11}$ 8 cm$^{-2}$ sous 60 keV pour une épaisseur d'oxyde de grille (2) de 35 nm.

5. Procédé selon les revendications 2 à 4, caractérisé en ce que l'on effectue une implantation d'ions d'arsenic (6) à $5 \times 10^{12}$ As cm$^{-2}$ sous 80 keV pour former les zones de mémoire (9).

6. Procédé selon les revendications 2 à 5, caractérisé en ce que, pour structurer les électrodes (8) de polysilicium 1, on applique un procédé de gravure anisotrope, de préférence une gravure réactive par crépitement dans un mélange de fréon (CF$_4$ ou CHF$_3$)-oxygène.

FIG 1

FIG 2

FIG 3

FIG 4

# FIG 5

# FIG 6

# FIG 7

# FIG 8

# FIG 9